# EUROPEAN PATENT SPECIFICATION

(11) **EP 2 811 508 B1**
(45) Date of publication and mention of the grant of the patent: **24.04.2019**
(21) Application number: 13171157.4
(22) Date of filing: 07.06.2013
(51) Int. Cl.: H01J 37/32, H01J 37/34, C23C 14/35

(54) **Gas configuration for magnetron deposition systems**
Gaskonfiguration für Magnetron-Abscheidungssysteme
Configuration de gaz pour systèmes de dépôt au magnétron

(43) Date of publication of application: 10.12.2014
(73) Proprietor: Soleras Advanced Coatings bvba, 9800 Deinze (BE)
(72) Inventor: De Bosscher, Wilmert, 9031 Drongen (BE)
(74) Representative: Wauters, Davy Erik Angelo

(56) References cited:
- DE-A1-102008 028 542
- US-A1- 2001 013 470
- US-A1- 2005 011 757
- US-A1- 2010 078 309

## Description

### Field of the invention

The invention relates to the field of magnetron deposition devices. More specifically it relates to a magnetron deposition system comprising multiple magnetron units and the configuration of the gas inlet therein.

### Background of the invention

Sputter deposition has become a widespread technique to add functionalities to substrates such as film, sheet form materials or more complex shaped 3-dimensional objects. In a low-pressure sputter deposition coater, ionized gas ions are accelerated towards a negatively biased target. Atoms are kicked out of the target when the gas ions impinge on its surface. A magnet system may be provided under the target surface to confine the free electrons in a racetrack. Within the racetrack the ionization degree of the gas is greatly increased and the ion bombardment of the target is therefore more intense below the racetrack. Hence the magnet system defines the area on the target from which atoms are sputtered away. Moreover, under the racetrack, target atoms are ejected mainly in a direction according to a Lambertian distribution perpendicular to the surface of the target. Such a process is known as magnetron sputter deposition. The knocked-out atoms hit the substrate surface where a dense coating forms. When also reactive gasses are admitted into the coater, reactions with the impinging target atoms will occur at the surface of the substrate, enabling the formation of compound materials such e.g. as oxides or nitrides.

In order to improve the efficiency of the plasma generation and the sputtering process, it is known to increase the sputter gas pressure. Nevertheless, in turn, deposition efficiency is reduced. Therefore, known solutions include an increase of the gas pressure in localized zones, advantageously near the targets.

In US patent application 2010/270144, a sputter coater is described wherein the feed gas is injected between different cathode segments. The gas source thereby can include non-reactive gases, reactive gases or a mixture thereof. Although gas is released close to the targets, the position of the gas inlets in combination of the nature of gas when it is released in a vacuum system, still results in a significant part of the gas being spread in the vacuum system without passing the plasma region.

In US patent application 2001/0013470 A1, a magnetron sputtering apparatus is described wherein an inert gas is injected into the space between two opposing magnetron units. The sputtered particles react with a reactive gas injected between a partition plate and the substrate.

Direct injection of gas in the plasma region is described in "Magnetron with gas injection through hollow cathodes machined in sputtered target", Surface and Coatings Technology, (148) 296-304. Musil et al. describe a magnetron equipped with a target with holes through which sputtering gas is directly injected inside the magnetron discharge. The targets used in such a system need to be specifically processed to provide the feedthroughs through which the gas is to be injected. Furthermore, the need for gas feedthroughs through the magnetron system also results in an increased complexity of the magnetron unit. In addition, drilling holes in the zone that contains a strong confinement of the free electrons and on a target material having a negative potential, will generate a high risk of discharges and arcing at the edges of these holes. Chamfering may resolve the latter issue. However it will not prevent that even a larger significant part of valuable target material is removed at the exact location where the sputtering erosion is most efficient and as such, will further reduce the target material consumption efficiency.

Gas flow sputtering is known whereby a gas flow is used for forcing sputtered particles towards a substrate. Such a technique is described for example in Journal of Magnetism and Magnetic Materials 321 (2009) 872-875.

Where reactive sputtering is envisaged, it is known to supply the sputter gas closer to the target and the plasma region while supplying the reactive gas closer to the substrate. US patent 5,792,324 discloses such a sputter system wherein the reactive gas is provided near the substrate and wherein the sputter gas is provided near the target.

An alternative deposition technique for sputter deposition is plasma assisted chemical vapour deposition (PA-CVD), also referred to as plasma enhanced chemical vapour deposition (PE-CVD). Chemical vapour deposition (CVD) is a chemical process for producing solid material, e.g. films on substrates. During chemical vapour deposition, the substrate is exposed to one or more volatile precursors, which react and/or decompose on or near the substrate surface for producing the desired coating on the substrate. During plasma assisted chemical vapour deposition, plasma is utilized for enhancing the chemical reaction rate of one or more of the precursors. The efficiency of the interaction between the precursor and the plasma thereby determines the degree wherein the chemical reaction rate of the precursors can be improved.

There is a need for efficient magnetron deposition systems.

### Summary of the invention

It is an object of embodiments of the present invention to provide a magnetron deposition system with efficient plasma formation.

It is an advantage of embodiments of the present invention that efficient plasma formation is obtained resulting in efficient and homogeneous depositing of materials, at low pressures.

It is an advantage of at least some embodiments of the present invention that a magnetron sputter deposition system is provided wherein conventional sputter targets or targets that can be easily manufactured with existing manufacturing techniques can be used.

The above objective is accomplished by a method and device according to the present invention as defined by the claims.

The present invention relates to a magnetron deposition system for depositing material or for performing a plasma treatment, the magnetron deposition system comprising at least two magnetron units, each magnetron unit comprising a magnet configuration, the at least two magnetron units being arranged so that the magnetron units at least partly share a common plasma in a plasma region between the at least two magnetron units, and at least one gas inlet for supplying a first gas, wherein the at least one gas inlet for supplying a first gas and the at least two magnetron units are arranged for directly injecting the first gas in the plasma region between the two magnetron units.

It is to be noticed that with at least partly sharing a common plasma there is meant that at least a fraction of the magnetic field lines or plasma is to be shared between the at least two magnetron units, but that part of the plasma also may be local to a local racetrack at a specific magnetron unit. Such a fraction may e.g. be at least 5% of the plasma, e.g. at least 15% of the plasma, e.g. at least 50% of the plasma.

In embodiments of the present invention, the first gas can be injected in the gap between the magnetron units, e.g. when using sputter magnetron units for sputtering material this may be between the targets' surfaces, which, due to the particular arrangement, is a region with maximum magnetic flux density. This region is the plasma region. It is an advantage of embodiments of the present invention that the magnetron sputter deposition system allows working, i.e. allows ionization, at lower pressures.

The magnetron deposition system further may comprise at least one further gas inlet for supplying alternative gas of different composition, the further gas inlet being distinct from the gas inlet for supplying the sputter gas. It is an advantage of embodiments of the present invention that both gas of different composition and sputter gas can be delivered separately from each other, allowing to introduce them under individual conditions optimized for the depositing process, e.g. for the sputtering process. The alternative gas of different composition may contain or consist of a reactive gas.

The further gas inlet may be arranged with respect to the magnetron units so as to inject alternative gas outside the plasma region between the magnetron units. It is an advantage of at least some embodiments of the present invention wherein sputtering from targets is applied, that the alternative gas is lead further away from the targets, thereby less or not impacting the targets in any way, e.g. by chemical reaction.

The further gas inlet may comprise a segmented gas line comprising a plurality of gas inlets for feeding reactive gas.

The gas inlet may comprise a segmented gas line comprising a plurality of gas inlets for feeding first gas. It is an advantage of embodiments for the present invention that first gas can be fed homogeneously to the plasma region between the targets.

The magnetron deposition system furthermore comprises blocking elements for blocking the first gas from leaking away via a region outside the plasma region and for forcing the first gas into the plasma region.

The blocking elements are structural elements, wherein part of the structural elements have a shape complementary to a backside of the magnetron unit, so the structural elements and the magnetron unit can be arranged adjacent each other. It is an advantage of the present embodiment that the plasma region is enclosed in the region between the magnetron units, reducing leak on the sides of the magnetron units.

The blocking elements may be part of a housing.

The gas inlet may be a gas manifold. It is an advantage of embodiments of the present invention that use can be made of a localized high pressure, forcing the gas into the less dense plasma region.

The at least one gas inlet may be connected to an electrode of a power source and may be configured for ionizing gas passing through the gas inlet.

The at least one gas inlet may be configured so that the injected gas is partially ionized when leaving the gas inlet. The at least one gas inlet may be configured to form a virtual anode during sputtering. It is an advantage of embodiments of the present invention that problems regarding disappearing anode and anode contamination can be reduced or avoided. It is an advantage of embodiments of the present invention that the virtual anode can function as electron conduction path.

According to at least some embodiments of the present invention, the magnetron deposition system may be a magnetron sputter deposition system. The system thus may be adapted for sputtering material. The magnetron units may be sputter magnetron units, each sputter magnetron unit comprising a magnet configuration and a mounting surface for mounting a target thereto. The at least one gas inlet for supplying a first gas may be a gas inlet for providing a sputter gas.

In one embodiment, the targets, upon being mounted, are oriented such that their sputter target surface can be directly seen by the substrate. The latter results in the possibility of having a controlled sputtering process and a high deposition rate.

It is an advantage of embodiments of the present invention that a system is provided that allows efficient ionization without the need for complex manufacturing techniques of the targets of the sputter magnetron units. The entirety of each targets' surface participates furthermore in the sputtering process because no extra holes, corners or surfaces are introduced. The deposition of material in the substrate can thus be highly efficient.

It is an advantage of embodiments of the present invention that a system is provided in which the majority of ions impinging on the target surface in order to realize sputter erosion is originating from at least one gas inlet. As such the chemical reactivity of arriving gas ions onto the target surface con be controlled, reduced or virtually eliminated, depending on the specific gas delivery conditions from this gas inlet.

The at least two sputter magnetron units may be adapted for receiving tubular sputter targets. It is an advantage of embodiments of the present invention that use can be made of tubular sputter targets, allowing to have a more efficient use of target material during the sputtering process.

The magnetron sputter deposition system furthermore may comprise a plurality of blades arranged between the housing and the tubular sputter targets so as to reduce gas leaking outside the plasma region. It is an advantage of embodiments of the present invention that use can be made of e.g. doctor blades or linear seals to further avoid leakage of sputter gas outside the plasma region.

The at least one gas inlet may be configured so that the injected gas is a reactive gas that is partially incorporated in the deposited material, deposited on a substrate. The gas inlet may therefore be connected to a vessel comprising reactive gas.

The gas inlet and the magnetron units may be configured so as to decompose the gas provided through the gas inlet by energy provided by the magnetron units.

The gas inlet may be arranged so that decomposed gas contributes to the deposited material, deposited on a substrate.

The system may be especially suitable for plasma assisted chemical vapour deposition. In such embodiments, a precursor, e.g. corresponding with or carried by the first gas, may be injected in the plasma. The injection into the plasma then may result in efficient activation and/or cracking of the precursor gas by the energy of the magnetrons (i.e. by the energy of the plasma). The activated or cracked precursor gas then may be incorporated in the deposited material

The present invention also relates to a vacuum apparatus for plasma coating of a surface, the vacuum apparatus comprising a vacuum chamber, a substrate holder for positioning a substrate and a magnetron deposition system as described above.

The present invention also relates to the use of a magnetron deposition system as described above for depositing material, e.g. depositing a coating on an object or for plasma treatment of an object. Depositing on an object may for example encompass a sputtering process as well as a plasma assisted chemical vapour deposition process.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 illustrates a schematic representation of a magnetron sputter deposition system with a gas distribution system according to an embodiment of the present invention.
FIG. 2 illustrates a schematic representation of another magnetron sputter deposition system with a gas distribution system according to an embodiment of the present invention.
FIG. 3 illustrates a schematic representation of still another magnetron sputter deposition system with a gas distribution system according to an embodiment of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Where in embodiments of the present invention reference is made to "sputter gas", reference is made to a gas or gas mixture used in the sputtering process of the target. Typically, sputter gas is ionized thus forming a plasma. In certain embodiments, sputter gas can be argon, which typically will be ionized to Ar⁺.

Where in embodiments of the present invention reference is made to alternative gas, reference is made to a gas or gas mixture introduced to provide interaction with the sputtered particles during deposition to form e.g. an alloy on the substrate. In general, reactive gas is desired strictly outside the plasma region, as interaction with the sputter target typically may lead to poisoning of the targets, rendering these not conductive anymore and resulting in a reduction of the sputter process, especially when DC sputtering is used.

Where in embodiments of the present invention reference is made to a DC power supply, it will be clear to the skilled person that reference is made to a DC power supply as well as to a power supply operating in pulsed DC mode. However the use of AC power supplies, HiPIMS power supplies or RF power supplies may equally be used and providing similar advantage as described in the embodiments.

Where in embodiments of the present invention reference is made to a magnetron sputter deposition system, reference is made to an assembly of at least two magnetron sputter units each suitable for supporting a target from which material can be sputtered. The magnetron sputter deposition system optionally also may comprise other components. It is to be noticed that embodiments of the present invention are not limited to sputter deposition system, but that for example more generally magnetron systems also are envisaged and within the scope of the claims. The latter can for example be obtained by selecting as a target material a material that results in a low or no sputter rate. Where in embodiments of the present invention reference is made to magnetron sputter deposition systems, reference therefore also is made to systems adapted for plasma treatment of objects, and not strictly for coating of an object. Alternatively, the magnetron system as presented in the current embodiments may advantageously be used for facilitating the deposition of PACVD or mixed PVD/PACVD layers, e.g. by providing complex gas molecules through the one gas inlet followed by a reaction in the energy of the magnetron sources. The systems thus are not limited to sputtering systems but may be more generally adapted for depositing materials on objects or for processing objects. Nevertheless, such processing systems nevertheless still will be referred to as a magnetron deposition system in embodiments of the present invention.

Where in embodiments of the present invention reference is made to a magnetron sputter unit reference is made to a combination of a magnet configuration and a target holder with a mounting surface for mounting a single target. Optionally also other components can be included as will be described further.

Where in embodiments of the present invention reference is made to a virtual anode, reference is made to the situation wherein a positively charged plasma plume or zone acts as an anode and thus acting as a conductive path for electrons. Use is made of the word "virtual" as it does not refer to a fixed mechanical element such as a piece of metal, but it refers to a spacious region, like a cloud of ions, which is not fixed, but continuously changes/renews. An advantage thereof is that e.g. deposition of materials on the virtual anode is not really possible and therefore poisoning of such an anode is also is avoided.

In a first aspect, embodiments of the present invention relate to a magnetron deposition system suitable for depositing a coating or layer on an object such as for example a substrate or for plasma treatment of an object. The substrate to be coated or treated, may be a conventional plate like substrate, may be a sheet-like material, may be one or more 3-dimensional objects, etc. It is to be noticed that embodiments of the present invention are not limited by the type of substrates, the deposition materials or gasses that may be used.

The magnetron deposition system comprises at least two magnetron units, each magnetron unit comprising a magnet configuration, the at least two magnetron units being arranged so that the magnetron units at least partly share a common plasma in a plasma region between the at least two magnetron units. The magnetron deposition system also comprises at least one gas inlet for supplying a first gas. The at least one gas inlet for supplying the first gas and the at least two magnetron units are arranged for directly injecting the first gas in the plasma region between the two magnetron units. The system may be a sputtering system applied for sputtering processes, although the invention is not limited thereto and for example plasma-enhanced chemical vapour deposition systems also may be envisaged, as well as combined plasma-enhanced chemical vapour deposition - physical vapour deposition systems or plasma treatment systems. The sputtering processes that may be involved may be conventional sputtering processes, reactive sputtering processes, etc. embodiments of the present invention not being limited thereto. It is to be noticed that the sputtering device and process according to some embodiments of the present invention are related to magnetron sputtering, the latter being indicative of the fact that a magnet configuration is used to confine the plasma near the sputtering target.

In the following, a plurality of magnetron sputter deposition systems will be described by way of examples of embodiments of the present invention. Although in a plurality of embodiments described below, reference is made to sputtering, sputter systems, sputter units, etc. , features and advantages thereof may be mutates mutandis be applied to other systems within the scope of the claims e.g. plasma assisted CVD systems, plasma treatment systems and combined plasma assisted CVD and physical vapour deposition system.

According to some embodiments of the present invention, the magnetron sputter deposition system comprises two or more magnetron sputter units. In a number of embodiments, exactly two magnetron sputter units will be used. Nevertheless, systems with three, four or more magnetron sputter units also may be present. Each magnetron sputter unit typically comprises a magnet configuration and a target holder comprising a mounting surface for mounting a sputter target. The magnet configuration may comprise a single magnet, a magnet array, a double magnet, a double magnet array, three magnets, a triple magnet array, etc. The number and type of magnets used may typically depend on the sputter target that is to be sputtered. In case of tubular targets, the magnets used typically will be inserted inside the tubular targets, and in view of the typical lengths of tubular targets, typically a triple magnet array is often selected. When the target holder is adapted for carrying a planar target, typically a magnet configuration is selected that results in a racetrack erosion of the target material. The magnets used typically may be a permanent, although inventions are not limited thereto. The target holder of each magnet configuration may, in some embodiments, be adapted for supporting tubular targets, for supporting planar targets, etc.

According to embodiments of the present invention, the magnetron sputter units are arranged so that the magnetron sputter units can at least partly share a common plasma in a plasma region between neighbouring targets when these are positioned in the magnetron sputter units. In one embodiment, the possibility of at least partly sharing a plasma is established by selecting magnetron configurations in neighbouring magnetron sputter units that have magnetic systems with opposite polarity. A plurality of magnet configuration can be used for such configurations with opposite polarity.

According to embodiments of the present invention, the magnetic configurations are arranged so that magnetic field lines are shared between neighbouring magnetron units of the at least two magnetron sputter units. In particular embodiments, at least 5%, advantageously at least 15% or even in some cases at least 50% of the magnetic field lines of specific magnet arrays are shared between specific magnet arrays of neighbouring magnetron sputter units. More particularly, when a plurality of magnet arrays is present in a magnetron unit, one of the magnet arrays may be positioned with respect to their surroundings so that they allow more easily sharing of magnetic field lines with specific magnet arrays of other magnetron sputter units. Other specific magnet arrays - not having such a position - may for example have magnetic field lines closing upon themselves or closing between specific magnet arrays of a same magnetron sputter unit. It is an advantage of embodiments of the present invention that targets mounted to different magnetron sputter units can easily share electrons and plasma current, even if the sputtering process and/or sputtering conditions is different for the different magnetron sputter units.

The shortest distance between target surfaces of different targets when supported by the magnetron sputter units may be smaller than 150mm, e.g. smaller than 100mm or smaller than 50mm.

The magnetron sputter units may be adapted for supporting tubular targets. It is an advantage of embodiments of the present invention that tubular targets can be used, typically resulting in a better use of sputter target material than when flat or planar targets are used. The rotation direction of the tubular targets may be chosen on purpose to be clockwise, counterclockwise or even more preferably a combination of both for a pair of tubular targets. The preferred direction and speed of rotation may result in a higher deposition rate because chemisorption at the target surface may be controlled or reduced.

In particular embodiments, wherein the magnetron sputter units are adapted for using tubular targets having a rotational axis, the distance between rotational axis of neighbouring tubular targets may be smaller than 300mm, e.g. smaller than 250mm or even smaller than 200 mm.

It further is to be noticed that the magnetron sputter units are arranged so that the sputter surface of (all) the targets, when mounted, can be directly seen by the substrate to be sputtered.

According to embodiments of the present invention, the system furthermore comprises at least one gas inlet for supplying the sputter gas. The at least one gas inlet for supplying a sputter gas and the at least two sputter magnetron units thereby are arranged for directly injecting the sputter gas in the common plasma region between the two sputter magnetron units. The at least one gas inlet may be a single gas inlet, a gas manifold, etc. In some embodiments, where oblong targets are used, the gas inlet may extend along the targets so that sputter gas is provided along the full length of the targets. By providing a gas inlet that injects directly into the region where the magnetic field is high, efficient ionization and plasma generation is obtained. The sputter gas may be injected from a plurality of gas inlets formed by a segmented gas line. It thereby is an advantage that sputter gas can be fed homogeneously to the plasma region between the targets.

According to the embodiments, it is prevented that the sputter gas provided leaks away in the vacuum system through regions where the plasma is not present. The system therefore comprises a blocking means for preventing the supplied gas from leakage. Such a blocking means is a structural means. In one example, such blocking means may be part of the housing wherein the magnetron sputter units are present. Such a blocking means may for example be made of any suitable materials, such as for example metal or other materials that can be used in vacuum systems and that do not suffer too much of deterioration under sputter conditions. The blocking means are adapted in shape, they have a part having a shape complementary to a backside of the sputter magnetron units, so that the structural elements and the sputter magnetron units can be arranged adjacent each other, preventing open space through which gas can easily spread. According to some embodiments, the gas inlet thus may be enclosed between the housing, the magnetron sputter units and an opening between the magnetron sputter units coinciding with the region of high magnetic field between the magnetron sputter units, where the common plasma will be present during sputtering.

According to some embodiments, besides a large blocking means for at least partly enclosing the gas supply, also additional blocking means may be present. Such additional blocking means may for example be one or more blades, brushes, wipers, seals, lubricants or combinations thereof that allow blocking small openings between the magnetron sputter units and the housing. For instance, a system analogous to 'Doctor blades', used in printing technology, may be added. Alternatively or in addition thereto, also gas blades may be used, whereby a sheet like gas flow prevents other gas from passing a region. This system may be particularly applicable to particular embodiments of the present invention including rotatory tubular targets. Because of the rotation of the tubular targets, the targets do not rest on a surface, but must be axially attached to a rotatable arm. A small gap to enable movement must be present between the base of the structure and the targets. Sputter gas may leak through this gap instead of enter the plasma region if no additional blocking means are provided. Additional blocking means formed by blades or brushes may prevent the leakage according to one preferred embodiment.

Gas leakage may be reduced as well by incorporating additional gas gates in the small gap preventing gas from the supply to pass this region of higher pressure. A gas gate is an additional gas supply system creating a back flow or higher pressure regime in a small zone and preventing other gasses to easily pass.

In another embodiment, an additional gas supply may be used for locally increasing gas pressure which may result in the supplied sputter gas being advantageously directed in another direction. In a particular embodiment, the system furthermore may be adapted for reactive sputtering. According to the embodiment, the magnetron sputter deposition system furthermore comprises a further gas inlet for supplying alternative gas. The supply for alternative gas advantageously is distinct from the gas inlet for supplying the sputter gas, so both gasses can be delivered separately from each other, allowing to introduce them under individual conditions optimized for the sputtering process. The gas inlet for alternative gas may be a single gas inlet, a gas manifold, etc. In one embodiment the gas inlet for alternative gas may be introduced as a segmented gas line. According to embodiments of the present invention, the further gas inlet may be arranged with respect to the sputter magnetron units so as to - in operation - inject alternative gas outside the plasma region between the sputter magnetron units. For example, the alternative gas inlet may be positioned at the side of the target opposite to the plasma region. The avoidance of alternative gas in the plasma region ensures that targets can maintain conductive during operation and reduces the need of a clean-up step to remove surface contamination.

The magnetron sputter units and/or the magnetron sputter deposition system may furthermore comprise further components such as for example cooling means and/or heating means, rotation means if e.g. rotatable targets are used, ... One or more of these components may be implemented in one or more end blocks.

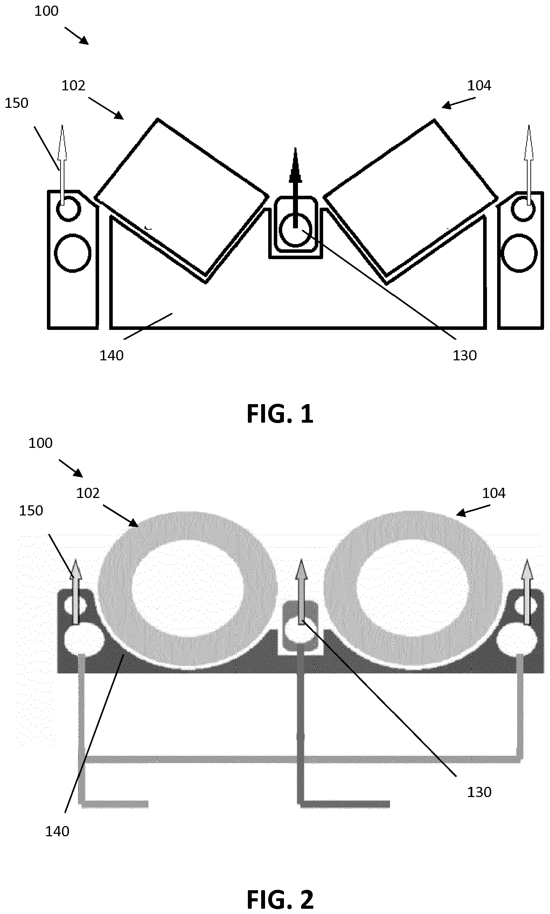

By way of illustration, embodiments of the present invention not being limited thereto, some particular examples will be further described with reference to FIG. 1 to FIG. 3.

In a first example shown in FIG. 1, an exemplary magnetron sputter deposition system is described showing standard and optional components of such a system. The system illustrates a first and second magnetron sputter unit 102, 104, a housing 140 at least partly complementary in shape with the magnetron sputter units 102, 104 , a gas inlet for supplying sputter gas 130 enclosed by the magnetron sputter units 102, 104 and the housing 140 so that the gas is supplied to a region of high magnetic field where a common plasma will be present during sputtering. Furthermore a gas inlet for supplying reactive gas 150 also is indicated, in the present example being provided as a separate unit, separate from the housing, although embodiments are not limited thereto. In the present example, flat sputter targets are shown, although the system may equally work with tubular sputter targets.

In a second example shown in FIG. 2, an exemplary magnetron sputter deposition system according to FIG. 1 is indicated, wherein the system is adapted for operating with tubular targets instead of flat targets.

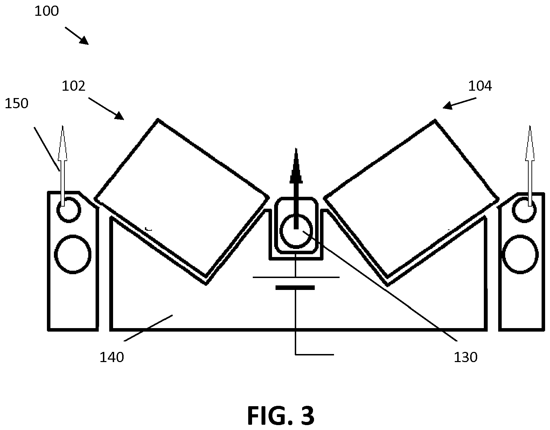

In a third example, a magnetron sputter deposition system is described, e.g. similar as the systems described in other embodiments of the present invention, but wherein the gas supply is put on a positive voltage. The latter can be performed by connecting it to a positive electrode of a power source, e.g. a power supply used for powering the magnetron sputter units, although embodiments are not limited thereto. An exemplary system of such an embodiment is shown in FIG. 3. By putting the gas supply at positive voltage, the injected gas can be ionized and form a plasma plume. An advantage of such a plasma plume is that problems regarding anode contamination and disappearing anodes can be avoided. The plasma plume thus acts as a virtual anode which can function as electron conduction path. The continuous injection of sputter gas allows for maintenance of the virtual anode formed by the ionized sputter gas atoms.

In at least some embodiments, the present invention relates to a system for depositing a coating on a substrate, wherein at least a fraction of the coating composition contains a material that is being provided through the gas inlet. The fraction may comprise material that is directly provided through the gas inlet, or may be material based on the material provided by the gas inlet but altered, e.g. cracked, through interaction with the plasma. The system described in embodiments of the present invention may be especially useful as it allows good, increased or even optimum interaction between the material provided through the gas inlet and the plasma generated in the system. In some examples, the system may be especially suitable for performing plasma enhanced chemical vapour deposition, whereby at least one of the precursors used in the process is provided through the gas inlet, whereby the gas inlet is directing its output into the plasma shared by the magnetron units. Other components which are known components of a plasma enhanced chemical vapour deposition setup such as for example further precursor inlets, heating elements, substrate holders, .... can also be part of systems according to embodiments of the present invention. Such systems thus may comprise other components typically available in known plasma enhanced chemical vapour deposition systems, as known to the skilled person. It is an advantage of embodiments according to the present invention that gas introduction into the plasma can be performed in an efficient way, thus assisting in rendering gas components reactive and/or in cracking gas components.

In another aspect, the present invention relates to a vacuum apparatus for plasma assisted coating or plasma treatment of a surface of an object, e.g. of a surface of an object. Examples of plasma assisted coating techniques may be sputtering techniques, plasma enhanced chemical vapour deposition techniques, combinations of physical vapour deposition and plasma enhanced chemical vapour deposition techniques, etc. Such an apparatus typically may comprise a vacuum chamber, a substrate holder for positioning a substrate and a magnetron deposition system as described in embodiments of the first aspect. It is to be noticed that the apparatus typically also may comprise a number of other standard and optional components such as for example a vacuum pump, valves, windows, cooling elements, heating elements, transport systems, etc., these elements not being described in more details as these are not essential to the characterizing elements of the present invention and as these are known by the person skilled in the art.

In yet another aspect, the present invention relates to the use of a magnetron sputter deposition system as described in the first aspect for depositing a coating on an object and/or for plasma treatment of an object.. Such a use typically may be performed in a vacuum system. The method advantageously may be a reactive sputtering method, a plasma enhanced chemical vapour deposition method, a combination of a physical vapour deposition method and a plasma enhanced chemical vapour deposition method, etc. embodiments of the present invention are not limited thereto. Further method steps of the use may correspond with the functionality of one or more of the components described in the first aspect of the present invention.

## Claims

1. A magnetron deposition system (100) for depositing material, the magnetron deposition system (100) comprising
- at least two magnetron units (102, 104), each magnetron unit (102, 104) comprising a magnet configuration, the at least two magnetron units (102, 104) being arranged so that the magnetron units (102, 104) at least partly share a common plasma in a plasma region between the at least two magnetron units,
- at least one gas inlet (130) for supplying a first gas,
wherein the at least one gas inlet (130) for supplying the first gas and the at least two magnetron units (102, 104) are arranged for directly injecting the first gas in the plasma region between the two magnetron units,
the magnetron deposition system (100) furthermore comprising blocking elements for blocking the first gas from leaking away via a region outside the plasma region and for forcing the first gas into the plasma region,
**characterised in that** the blocking elements are structural elements (140), wherein part of the structural elements (140) have a shape complementary to a backside of the magnetron unit (102, 104), so that the structural elements (140) and the magnetron unit (102, 104) can be arranged adjacent each other.

2. The magnetron deposition system (100) according to claim 1, further comprising at least one further gas inlet (150) for supplying alternative gas, the further gas inlet (150) being distinct from the gas inlet (130) for supplying the first gas and/or the further gas inlet (150) being arranged with respect to the magnetron units so as to inject alternative gas outside the plasma region between the magnetron units (102, 104) .

3. The magnetron deposition system (100) according to claim 2, wherein the further gas inlet (150) comprises a segmented gas line comprising a plurality of gas inlets for feeding alternative gas and/or wherein the gas inlet (130) comprises a segmented gas line comprising a plurality of gas inlets for feeding first gas and/or is a gas manifold.

4. The magnetron deposition system (100) according to claim 3, wherein the blocking elements (140) are part of a housing.

5. The magnetron deposition system (100) according to any of the previous claims, the magnetron deposition system (100) being a magnetron sputter deposition system (100), the magnetron units being sputter magnetron units (102, 104) further comprising a mounting surface for mounting a target, wherein the targets, when mounted, are directed such that the sputter target surface is directly visible from the substrate.

6. The magnetron deposition system (100) according to any of the previous claims, the magnetron deposition system being a magnetron sputter deposition system (100), the magnetron units being sputter magnetron units, wherein the at least two sputter magnetron units (102, 104) are adapted for receiving tubular sputter targets.

7. The magnetron deposition system (100) according to claim 6, wherein the system (100) furthermore comprises a plurality of blades arranged between the housing and the tubular sputter targets so as to reduce gas leaking outside the plasma region.

8. The magnetron deposition system (100) according to any previous claim, wherein the at least one gas inlet (130) is connected to an electrode of a power source and is configured for ionizing gas passing through the gas inlet (130).

9. The magnetron deposition system (100) according to claim 8, wherein the at least one gas inlet is configured so that the injected gas forms a virtual anode.

10. The magnetron deposition system (100) according to any of claims 1 to 5, wherein the at least one gas inlet is configured so that the injected gas is a reactive gas that is partially incorporated in the deposited material, deposited on a substrate.

11. The magnetron deposition system (100) according to claim 10, wherein the gas inlet (130) and the magnetron units (102, 104) are configured so as to decompose the gas provided through the gas inlet (130) by energy provided by the magnetron units (102, 104).

12. The magnetron deposition system (100) according to claim 11, wherein the gas inlet (130) is arranged so that decomposed gas contributes to the deposited material, deposited on a substrate.

13. A vacuum apparatus for plasma coating of a surface, the vacuum apparatus comprising a vacuum chamber, a substrate holder for positioning a substrate and a magnetron sputter deposition system (100) according to any of claims 1 to 12.

14. Use of a magnetron sputter deposition system (100) according to any of claims 1 to 12 for depositing a coating on or treatment of an object.

## Patentansprüche

1. Magnetron-Abscheidungssystem (100) zum Abscheiden von Material, wobei das Magnetron-Abscheidungssystem (100) umfasst
- zumindest zwei Magnetroneinheiten (102, 104), wobei jede Magnetroneinheit (102, 104) eine Magnetkonfiguration umfasst, wobei die zumindest zwei Magnetroneinheiten (102, 104) so angeordnet sind, dass die Magnetroneinheiten (102, 104) zumindest teilweise ein gemeinsames Plasma in einem Plasmabereich zwischen den zumindest zwei Magnetroneinheiten teilen,
- zumindest einen Gaseinlass (130) zum Zuführen eines ersten Gases,
wobei der zumindest eine Gaseinlass (130) zum Zuführen des ersten Gases und die zumindest zwei Magnetroneinheiten (102, 104) zum direkten Einspritzen des ersten Gases in den Plasmabereich zwischen den zwei Magnetroneinheiten angeordnet sind,
wobei das Magnetron-Abscheidungssystem (100) weiterhin Blockierelemente zum Blockieren des ersten Gases, damit es nicht über einen Bereich außerhalb des Plasmabereichs ausströmt, und zum Vorstoßen des ersten Gases in den Plasmabereich umfasst,
**dadurch gekennzeichnet, dass** die Blockierelemente Strukturelemente (140) sind, wobei ein Teil der Strukturelemente (140) eine Form aufweisen, die komplementär zu einer Hinterseite der Magnetroneinheit (102, 104) ist, sodass die Strukturelemente (140) und die Magnetroneinheit (102, 104) benachbart zueinander angeordnet werden können.

2. Magnetron-Abscheidungssystem (100) nach Anspruch 1, weiter umfassend zumindest einen weiteren Gaseinlass (150) zum Zuführen von alternativem Gas, wobei sich der weitere Gaseinlass (150) vom Gaseinlass (130) zum Zuführen der ersten Gases unterscheidet und/oder wobei der weitere Gaseinlass (150) in Bezug auf die Magnetroneinheiten angeordnet ist, sodass alternatives Gas außerhalb des Plasmabereichs zwischen den Magnetroneinheiten (102, 104) eigespritzt wird.

3. Magnetron-Abscheidungssystem (100) nach Anspruch 2, wobei der weitere Gaseinlass (150) eine segmentierte Gasleitung umfasst, die eine Vielzahl von Gaseinlässen zum Einspeisen von alternativem Gas umfasst, und/oder wobei der Gaseinlass (130) eine segmentierte Gasleitung umfasst, die eine Vielzahl von Gaseinlässen zum Einspeisen von erstem Gas umfasst, und/oder ein Gasverteiler ist.

4. Magnetron-Abscheidungssystem (100) nach Anspruch 3,
wobei die Blockierelemente (140) Teil eines Gehäuses sind.

5. Magnetron-Abscheidungssystem (100) nach einem der vorstehenden Ansprüche, wobei das Magnetron-Abscheidungssystem (100) ein Magnetron-Zerstäubungsabscheidungssystem (100) ist, wobei die Magnetroneinheiten Zerstäubungs-Magnetroneinheiten (102, 104) sind, die weiter eine Montagefläche zum Montieren eines Ziels umfassen, wobei die Ziele, wenn sie montiert sind, so ausgerichtet sind, dass die Zerstäubungszielfläche vom Substrat aus direkt sichtbar ist.

6. Magnetron-Abscheidungssystem (100) nach einem der vorstehenden Ansprüche, wobei das Magnetron-Abscheidungssystem ein Magnetron-Zerstäubungsabscheidungssystem (100) ist, wobei die Magnetroneinheiten Zerstäubungs-Magnetroneinheiten sind, wobei die zumindest zwei Zerstäubungs-Magnetroneinheiten (102, 104) zum Aufnehmen rohrförmiger Zerstäubungsziele angepasst sind.

7. Magnetron-Abscheidungssystem (100) nach Anspruch 6, wobei das System (100) weiterhin eine Vielzahl von Blättern umfasst, die zwischen dem Gehäuse und den rohrförmigen Zerstäubungszielen angeordnet sind, sodass ein Ausströmen von Gas außerhalb des Plasmabereichs reduziert wird.

8. Magnetron-Abscheidungssystem (100) nach einem der vorstehenden Ansprüche, wobei der zumindest eine Gaseinlass (130) mit einer Elektrode einer Stromquelle verbunden ist und zum Ionisieren von Gas, das den Gaseinlass (130) durchströmt, konfiguriert ist.

9. Magnetron-Abscheidungssystem (100) nach Anspruch 8, wobei der zumindest eine Gaseinlass so konfiguriert ist, dass das eingespritzte Gas eine virtuelle Anode bildet.

10. Magnetron-Abscheidungssystem (100) nach einem der Ansprüche 1 bis 5, wobei der zumindest eine Gaseinlass so konfiguriert ist, dass das eingespritzte Gas ein Reaktionsgas ist, das teilweise in das abgeschiedene Material eingearbeitet wird, das auf einem Substrat abgeschieden wird.

11. Magnetron-Abscheidungssystem (100) nach Anspruch 10, wobei der Gaseinlass (130) und die Magnetroneinheiten (102, 104) konfiguriert sind, um das Gas, das durch den Gaseinlass (130) durch Energie bereitgestellt ist, die durch die Magnetroneinheiten (102, 104) bereitgestellt ist, zu zersetzen.

12. Magnetron-Abscheidungssystem (100) nach Anspruch 11, wobei der Gaseinlass (130) so angeordnet ist, dass zersetztes Gas zum abgeschiedenen Material, das auf dem Substrat abgeschieden wird, beiträgt.

13. Vakuumeinrichtung zur Plasmabeschichtung einer Fläche, wobei die Vakuumeinrichtung eine Vakuumkammer, einen Substrathalter zum Positionieren eines Substrats und ein Magnetron-Zerstäubungsabscheidungssystem (100) nach einem der Ansprüche 1 bis 12 umfasst.

14. Verwendung eines Magnetron-Zerstäubungsabscheidungssystems (100) nach einem der Ansprüche 1 bis 12 zum Abscheiden einer Beschichtung auf einem oder zur Behandlung eines Objekts.

## Revendications

1. Système de dépôt de magnétron (100) destiné à déposer un matériau, le système de dépôt de magnétron (100) comprenant
- au moins deux unités de magnétron (102, 104), chaque unité de magnétron (102, 104) comprenant
une configuration d'aimant, les au moins deux unités de magnétron (102, 104) étant agencées pour que les unités de magnétron (102, 104) partagent au moins en partie un plasma commun dans une région de plasma entre les au moins deux unités de magnétron,
- au moins une admission de gaz (130) destinée à fournir un premier gaz,
dans lequel la au moins une admission de gaz (130) destinée à fournir le premier gaz et les au moins deux unités de magnétron (102, 104) sont agencées pour injecter directement le premier gaz dans la région de plasma entre les deux unités de magnétron,
le système de dépôt de magnétron (100) comprenant de plus des éléments bloquants destinés à bloquer la fuite du premier gaz via une région en dehors de la région de plasma et à forcer le premier gaz dans la région de plasma,
**caractérisé en ce que** les aimants bloquants sont des éléments structurels (140), dans lequel une partie des éléments structurels (140) a une forme complémentaire d'un côté dorsal de l'unité de magnétron (102, 104), de sorte que les éléments structurels (140) et l'unité de magnétron (102, 104) peuvent être agencés adjacents les uns aux autres.

2. Système de dépôt de magnétron (100) selon la revendication 1, comprenant en outre au moins une admission de gaz supplémentaire (150) destinée à fournir un gaz alternatif, l'admission de gaz supplémentaire (150) étant distincte de l'admission de gaz (130) destinée à fournir le premier gaz et/ou l'admission de gaz supplémentaire (150) étant agencée par rapport aux unités de magnétron de manière à injecter un gaz alternatif en dehors de la région de plasma entre les unités de magnétron (102, 104).

3. Système de dépôt de magnétron (100) selon la revendication 2, dans lequel l'admission de gaz supplémentaire (150) comprend une ligne de gaz segmentée comprenant une pluralité d'alimentations de gaz destinées à alimenter en gaz alternatif et/ou dans lequel l'admission de gaz (130) comprend une ligne de gaz segmentée comprenant une pluralité d'admissions de gaz destinées à alimenter en un premier gaz et/ou est une rampe d'alimentation en gaz.

4. Système de dépôt de magnétron (100) selon la revendication 3,
dans lequel les éléments structurels (140) font partie d'un logement.

5. Système de dépôt de magnétron (100) selon l'une quelconque des revendications précédentes, le système de dépôt de magnétron (100) étant un système de dépôt par pulvérisation cathodique de magnétron (100), les unités de magnétron étant des unités de magnétron à pulvérisation cathodique (102, 104) comprenant en outre une surface de montage destinée à monter une cible, dans lequel les cibles, une fois montées, sont dirigées de telle sorte que la surface cible de pulvérisation cathodique soit directement visible du substrat.

6. Système de dépôt de magnétron (100) selon l'une quelconque des revendications précédentes, le système de dépôt de magnétron étant un système de dépôt par pulvérisation cathodique de magnétron (100), les unités de magnétron étant des unités de magnétron à pulvérisation cathodique, dans lequel les au moins deux unités de magnétron à pulvérisation cathodique (102, 104) sont adaptées pour recevoir des cibles de pulvérisation cathodique tubulaires.

7. Système de dépôt de magnétron (100) selon la revendication 6, dans lequel le système (100) comprend de plus une pluralité de pales agencées entre le logement et les cibles de pulvérisation cathodique tubulaires de manière à réduire la fuite de gaz en dehors de la région de plasma.

8. Système de dépôt de magnétron (100) selon une quelconque revendication précédente, dans lequel la au moins une admission de gaz (130) est raccordée à une électrode d'une source d'alimentation et est configurée pour ioniser un gaz passant à travers l'admission de gaz (130).

9. Système de dépôt de magnétron (100) selon la revendication 8, dans lequel la au moins une admission de gaz est configurée pour que le gaz injecté forme une anode virtuelle.

10. Système de dépôt de magnétron (100) selon l'une quelconque des revendications 1 à 5, dans lequel la au moins une admission de gaz est configurée pour que le gaz injecté soit un gaz réactif qui est partiellement incorporé dans le matériau déposé, qui est déposé sur un substrat.

11. Système de dépôt de magnétron (100) selon la revendication 10, dans lequel l'admission de gaz (130) et les unités de magnétron (102, 104) sont configurées de manière à décomposer le gaz fourni à travers l'admission de gaz (130) par l'énergie fournie par les unités de magnétron (102, 104).

12. Système de dépôt de magnétron (100) selon la revendication 11, dans lequel l'admission de gaz (130) est agencée pour que le gaz décomposé contribue au matériau déposé, qui est déposé sur un substrat.

13. Appareil à vide pour revêtement d'une surface par plasma, l'appareil à vide comprenant une chambre à vide, un porte-substrat destiné à positionner un substrat et un système de dépôt par pulvérisation cathodique de magnétron (100) selon l'une quelconque des revendications 1 à 12.

14. Utilisation d'un système de dépôt par pulvérisation cathodique de magnétron (100) selon l'une quelconque des revendications 1 à 12, destiné à déposer un revêtement sur ou un traitement d'un objet.
